Europäisches Patentamt

**(19)** European Patent Office

Office européen des brevets

**(11)** Numéro de publication : **0 313 521 B1**

**(12)** # FASCICULE DE BREVET EUROPEEN

**(45)** Date de publication du fascicule du brevet :
18.12.91 Bulletin 91/51

**(51)** Int. Cl.⁵ : **G11C 11/412**

**(21)** Numéro de dépôt : **88810725.7**

**(22)** Date de dépôt : **24.10.88**

**(54)** Mémoire à accès aléatoire.

**(30)** Priorité : 23.10.87 FR 8714682

**(43)** Date de publication de la demande :
26.04.89 Bulletin 89/17

**(45)** Mention de la délivrance du brevet :
18.12.91 Bulletin 91/51

**(84)** Etats contractants désignés :
CH DE GB LI

**(56)** Documents cités :
ELEKTRONIK, vol. 20, no. 4, avril 1971, pages
111-116, Munich, DE; E. HOLLE et al.: "Die
COS/MOS-Technik"
10E CONGRES INTERNATIONAL DE CHRO-
NOMETRIE, Genève, 11-14 septembre 1979,
no. 3, pages 285-289, La Sociéte Suisse de
Chronometrie, BÜren, CH; J.-C. MARTIN: "The
use of ROM'S and RAM'S in a wrist-watch"

**(73)** Titulaire : **CENTRE ELECTRONIQUE
HORLOGER S.A.
Maladière 71
CH-2000 Neuchâtel 7 (CH)**

**(72)** Inventeur : **Macken, Peter
Carrels 17
CH-2034 Peseux (CH)**
Inventeur : **Nys, Olivier
Gibraltar 1
CH-2000 Neuchâtel (CH)**

**(74)** Mandataire : **Brulliard, Joel
c/o CENTRE SUISSE D'ELECTRONIQUE ET DE
MICROTECHNIQUE S.A. Maladière 71
CH-2007 Neuchâtel (CH)**

## Description

La présente invention concerne une mémoire matricielle à accès aléatoire. Elle concerne plus particulièrement une mémoire en technologie CMOS qui présente une très faible consommation.

De telles mémoires sont bien connues. Leur domaine d'application privilégié comprend principalement les circuits destinés à équiper des appareils à alimentation autonome.

Dans une forme de réalisation connue, la mémoire est composée de cellules identiques disposées en lignes et en colonnes, chaque cellule comportant une bascule bistable, réalisée au moyen de deux inverseurs à transistors MOS complémentaires, et deux transistors interrupteurs MOS reliant les bornes de la bascule à deux bornes d'accès de la cellule. Les grilles de commande des transistors interrupteurs d'une cellule sont reliées à une ligne d'adressage, et les bornes d'accès de cette cellule aux deux bus d'information d'une colonne.

Dans une mémoire de ce type, il est bien connu que l'opération de lecture d'une cellule, ou d'écriture de cette cellule, doit être précédée d'une phase de précharge de tous les bus de la mémoire. Si cette précaution n'est pas prise l'information, contenue dans les cellules de la ligne dont fait partie la cellule considérée, peut être détruite.

La précharge consiste à porter les bus à une tension continue donnée. Comme chaque bus présente une capacité parasite relativement importante, le courant de charge de ces capacités est élevé et il représente une part importante de la consommation totale de la mémoire.

La consommation due à cette charge constitue un inconvénient important des mémoires statiques à faible consommation de l'art antérieur.

La présente invention se propose de pallier à cet inconvénient.

La mémoire à accès aléatoire selon l'invention, comportant une pluralité de cellules identiques disposées suivant m lignes et n colonnes et auxquelles sont connectés m lignes d'adressage et 2n bus d'information, chaque cellule étant constituée d'une bascule bistable et de deux interrupteurs commandés par une ligne d'adressage et reliant, chacun, une borne de sortie de la bascule à un bus d'information, est caractérisée en ce que chaque cellule comporte, en outre, des moyens d'isolement connectés, chacun, entre une des bornes de sortie de la bascule et le bus d'information qui lui correspond, en série avec un des interrupteurs, et dont la conduction, respectivement le blocage, est contrôlée par l'état du bus correspondant à l'autre borne de sortie de la bascule.

La présente invention a également pour objet un procédé selon les revendications 3 et 4.

La mémoire selon l'invention présente l'avantage que, sans utiliser de lignes de connexion supplémentaires, l'application de signaux logiques appropriés sur les bus d'une colonne permet d'isoler toutes les bascules de cette colonne, et donc de préserver l'information qu'elles contiennent. Dans ces conditions, il est possible d'assurer que la lecture d'une ou de plusieurs cellules ne nécessite la précharge que des bus de la ou des colonnes contenant cette ou ces cellules, les autres bus étant maintenus à un niveau logique assurant l'isolement des bascules qui leur correspondent. Ce même avantage existe pour la phase d'écriture. Ceci entraîne une réduction de la consommation d'autant plus importante que la mémoire est grande.

Les caractéristiques et avantages de l'invention ressortiront de la description qui va suivre, faite en regard des dessins annexés qui représentent, à titre d'exemple explicatif mais nullement limitatif, une forme de réalisation avantageuse d'une mémoire statique à accès aléatoire à transistors MOS complémentaires. Sur ces dessins, où les mêmes références se rapportent à des éléments analogues :

— la figure 1 représente le schéma d'une mémoire matricielle formée de cellules indentiques et connue dans l'art antérieur ;

— la figure 2 représente une cellule de mémoire selon l'invention ; et

— la figure 3 représente une mémoire matricielle comportant des cellules selon l'invention.

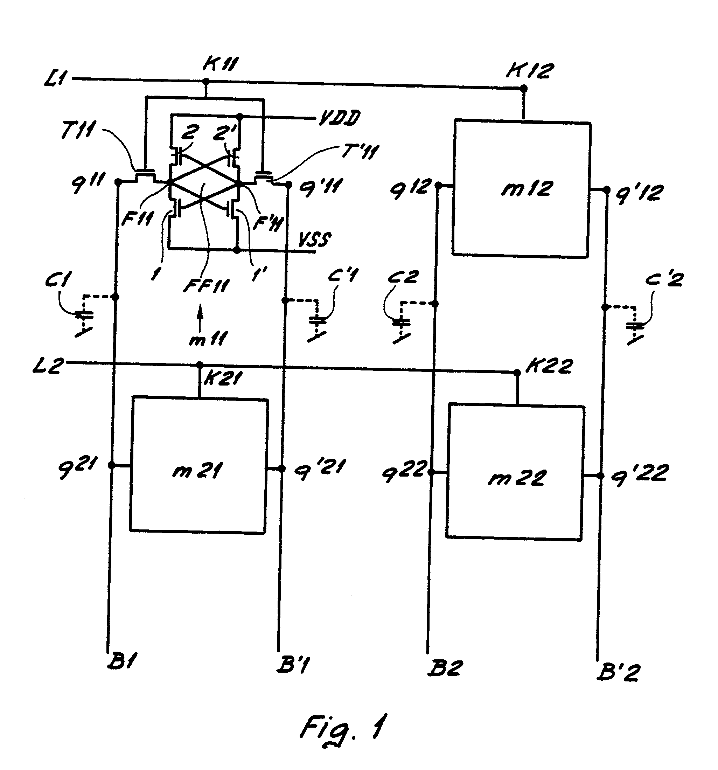

Avant de décrire une forme de réalisation de la mémoire selon l'invention, il est utile de rappeler auparavant la structure et le fonctionnement d'une mémoire statique matricielle à accès aléatoire connue de l'art antérieur. Cette mémoire, que est représentée sur la figure 1 est formée de quatre cellules identiques, référencées m11, m12, m21, m22, ces cellules étant disposées suivant deux lignes et deux colonnes. Bien entendu, la mémoire pourrait comporter davantage de cellules, qui seraient alors disposées suivant un nombre m de lignes et n de colonnes plus grand.

Toutes les cellules étant identiques, seule la structure interne de la cellule m11 a été représentée. Cette cellule comporte essentiellement une bascule bistable ou flip-flop FF11, et un premier et un deuxième transistors interrupteurs référencés respectivement T11 et T'11. La bascule est formée d'un premier et d'un deuxième inverseurs. Le premier inverseur comprend un transistor MOS du type N, référencé 1, et un transistor MOS du type P, référencé 2, ces deux transistors étant connectés en série entre une ligne d'alimentation négative VSS et une ligne d'alimentation positive VDD. Le deuxième inverseur comporte un transistor 1' et un transistor 2', ces transistors étant identiques respectivement aux transistors 1 et 2. La sortie du premier inverseur détermine une première borne F11 de la bascule, et elle est reliée aux grilles des transistors 1' et 2'. De même, la sortie du deuxième inverseur détermine une deuxième borne F'11 de la bascule, et elle est reliée aux grilles des transistors 1 et 2. Les transistors T11 et T'11 sont, dans l'exemple considéré, des transistors MOS de type N, le premier étant connecté entre la borne F11 et une première borne d'accès q11 de la cellule, et le deuxième entre la borne F'11 et une deuxième borne d'accès q'11 de cette cellule. Enfin, les grilles des transistors T11 et T'11 sont reliées à une borne de commande K11 de la cellule.

Les bornes K11, K12, des cellules M11, M12 appartenant à la première ligne de la mémoire sont connectées à une première ligne d'adressage L1. De même les bornes K21, K22 des cellules de la deuxième ligne sont connectées à une deuxième ligne d'adressage L2. Les bornes d'accès q11, q21 des cellules m11, m21, appartenant à la première colonne de la mémoire sont reliées à un premier bus d'information B1 de cette colonne, et les bornes q'11, q'21 de ces mêmes cellules à un deuxième bus d'information B'1. De même, les bornes q12, q22 et q'12, q'22 des cellules de la deuxième colonne sont reliées respectivement à un premier bus B2 et à un deuxième bus B'2 de cette colonne.

Le contenu de la mémoire est donné par l'état des bascules FF11... FF22, cet état étant défini par les niveaux logiques complémentaires existant respectivement aux bornes F11 et F'11... F22 et F'22. En dehors des phases d'écriture et de lecture, des lignes d'adressage L1, L2 sont au niveau logique bas. La bascule FF11 est ainsi isolée des bus B1, B'1 grâce aux transistors T11 et T'11 qui se trouvent à l'état bloqué. Les autres bascules étant également isolées des bus, ceux-ci présentent un niveau logique indéterminé.

Pour lire l'information se trouvant dans la cellule m11, la ligne L1 est portée au niveau logique haut, ce qui a pour effet, en rendant conducteurs les transistors T11, T'11, de relier la borne F11 au bus B1 et la borne F'11 au bus B'1. L'état logique de ces bus correspond donc à celui des bornes de la bascule FF11. La lecture de l'information peut alors être faite, de manière connue, en reliant aux bus B1, B'1 un amplificateur différentiel, dont la sortie délivre l'état logique de la cellule m11.

Une telle lecture correspond cependant à un cas idéal car, en réalité, les bus B1, B'1, B2 et B'2 présentent, par rapport à la masse, des capacités parasites référencées respectivement C1, C'1, C2 et C'2. Or, à chaque lecture de la mémoire, ces capacités sont chargées aux tensions auxquelles sont portés les bus, et elles peuvent garder cet état jusqu'à la prochaine lecture. Ainsi si, par exemple, la lecture de la cellule m11 suivait celle de la cellule m21, les bus B1, B'1 se trouveraient, juste avant la lecture de la cellule m11, aux niveaux logiques des bornes q21, q'21. Deux cas peuvent alors se présenter. Ou bien les bus B1, B'1 se trouvent aux mêmes niveaux logiques que respectivement les bornes F11, F'11, ou bien ils se trouvent à des niveaux logiques complémentaires.

Le premier cas correspond à celui où les cellules m21 et m11 contiennent la même information. La lecture de la cellule m11, consistant à porter au niveau logique "1" la ligne L1 pour rendre conducteurs les transistors T11 et T'11, elle n'entraîne dans ces conditions aucune circulation de courant entre les bornes F11 et q11, ni entre les bornes F'11 et q'11. Par contre, si les cellules m21 et m11 contiennent des informations différentes, lors de la lecture de la cellule m11, le bus B1, se trouvant par exemple au niveau "1", est relié à la borne F11 qui est au niveau "0". Bien entendu, le bus B'1 et la borne F'11 se trouvent respectivement aux niveaux "0" et "1". Les conditions seraient alors réunies pour entraîner un changement d'état de la bascule.

Il est évident que ce qui vient d'être dit pour la cellule m11 s'applique aussi à la cellule m12 dont l'information peut être détruite, au moment où la ligne L1 est portée au niveau logique "1", si les bus B2 et B'2 contiennent une information différente de celle de la bascule de cette cellule.

Pour éviter cet inconvénient majeur, il est nécessaire de porter, avant la lecture, les bus de toutes les colonnes au potentiel VDD, c'est-à-dire au niveau logique haut. Cette opération s'appelle la précharge des bus.

En portant la ligne d'adressage L1 au niveau "1", les bus étant préchargés, l'information contenue dans les cellules m11 et m12 est conservée si les cellules sont bien dimensionnées. En effet, en considérant la cellule m11, une des bornes de la bascule, par exemple F11, est aussi au niveau "1" et ce niveau ne changera pas une fois le transistor T11 mis en conduction. La borne F11 se maintenant au niveau logique haut, le transistor 1' se trouve à l'état conducteur et pourra décharger la capacité C'1 à travers T'11.

Pour introduire une information dans la cellule m11, il y a lieu d'imposer, par des moyens connus non représentés, aux bus B1 et B'1 des niveaux logiques complémentaires représentatifs de cette information, puis de porter la ligne d'adressage L1 au niveau logique haut. Les transistors T11 et T'11 se trouvent à l'état conducteur et, si la cellule est bien dimensionnée, les bornes F11 et F'11 de la bascule FF11 prendront les mêmes niveaux logiques que les bus B1 et B'1.

Si, au moment où la ligne L1 est portée au niveau logique "1", la cellule m11 reçoit bien la nouvelle information donnée par l'état des bus B1, B'1 par contre l'information contenue dans la cellule m12 risque d'être détruite pour les mêmes raisons que celles qui viennent d'être données à propos de la lecture. Pour éviter cette difficulté, il suffit, dans ce cas aussi, de précharger les bus B2, B'2 avant de porter la ligne L1 au niveau logique haut.

La précharge des bus, si elle permet de préserver l'information contenue dans les cellules faisant partie de la ligne sélectionnée dans la mémoire, entraîne cependant un supplément de consommation puisqu'elle consiste à porter un bus de chaque colonne au niveau logique "1", l'autre bus étant nécessairement déjà à ce niveau. Si la mémoire comporte un nombre élevé de colonnes, le courant nécessaire pour charger les capacités parasites associées à ces bus peut représenter la part prépondérante dans la consommation totale de la mémoire.

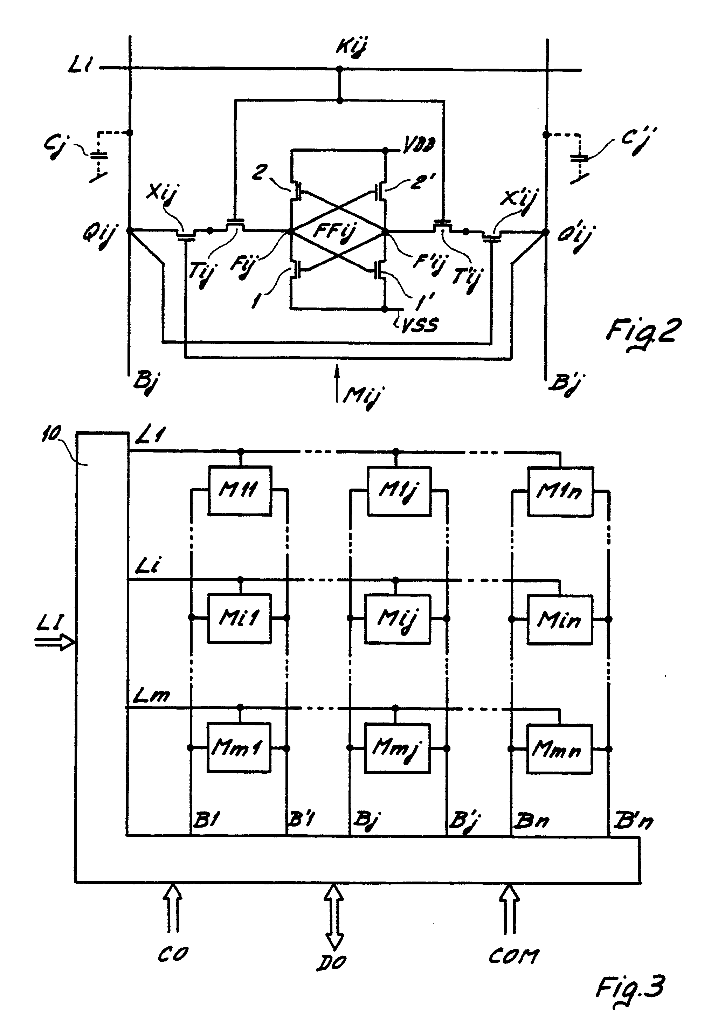

La présente invention a pour objet de fournir une mémoire présentant une consommation réduite. Ceci est obtenu en utilisant un type de cellule dont une forme de réalisation est représentée sur la figure 2. Cette cellule est référencée Mij, i prenant les valeurs de 1 à m, et j de 1 à n, si la mémoire comporte m lignes et n colonnes. La référence FFij désigne dans cette cellule une bascule, ou flip-flop, identique à la bascule FF11 de la figure 1. La bascule FFij comporte une première borne Fij qui est connectée à un premier transistor interrupteur Tij, et une deuxième borne F'ij qui est reliée à un deuxième transistor interrupteur T'ij, ces deux transistors étant identiques.

Les grilles des transistors Tij et T'ij sont connectées à une borne de commande Kij, laquelle est reliée à une ligne d'adressage Li de la mémoire. En série avec le transistor Tij est connecté un troisième transistor interrupteur Xij, les transistors Tij et Xij reliant ainsi la borne Fij à une première borne d'accès Qij de la cellule Mij. De même, en série avec le transistor T'ij est connecté un quatrième transistor interrupteur X'ij, ces deux transistors reliant la borne F'ij à une deuxième borne d'accès Q'ij de la cellule. Enfin, à la borne Qij sont reliés un premier bus Bj et la grille du transistor X'ij, alors qu'à la borne Q'ij sont reliés un deuxième bus B'j et la grille du transistor Xij.

Les transistors Xij et X'ij sont de même type que les transistors Tij T'ij.

Lorsque les bus Bj et B'j sont au niveau logique "0", le cellule est dans un mode non-opérationnel ou passif. Les grilles des transistors Xij et X'ij étant alors au niveau logique bas, ces transistors isolent la bascule FFij des bus, même si la ligne d'adressage Li se trouve au niveau logique haut. L'information contenue dans la bascule ne peut pas, dans ces conditions, être modifiée.

Lorsque les bus Bj et B'j sont au niveau logique "1" et que la ligne d'adressage Li est au niveau logique "0", les bus sont préchargés mais la bascule est isolée des bus par les transistors Tij T'ij.

Pour lire l'information contenue dans la cellule Mij, il faut d'abord précharger les bus, puis déconnecter les moyens de commande externes pour que les bus soient à haute impédance, enfin porter la ligne d'adressage Li au niveau logique "1". Si, dans ces conditions, la borne Fij est par exemple au niveau logique "0" et la borne F'ij au niveau "1", les transistors Tij et Xij étant conducteurs, la capacité Cj est déchargée à travers les transistors Xij, Tij et 1, ce qui fait passer le bus Bj au niveau logique "0". Quant au bus B'j, étant préchargé, il se trouve déjà au même niveau logique que la borne F'ij et cet état n'est pas modifié par la conduction des transistors T'ij et X'ij. Toutefois, à mesure que la capacité Cj se décharge, le transistor X'ij passe progressivement de l'état conducteur à l'état bloqué. Le bus B'j garde capacitivement son niveau logique haut. Il ne reste plus qu'à déterminer, à l'aide d'un amplificateur différentiel, les niveaux logiques des bus pour connaître l'information contenue dans la cellule.

Enfin, pour introduire une information dans la cellule Mij, il faut d'abord porter les bus Bj, B'j, aux niveaux logiques représentatifs de cette information, puis porter la ligne d'adressage Li au niveau logique "1". Dans ces conditions si, par exemple, les bus Bj et B'j sont respectivement aux niveaux "1" et "0" et les bornes Fij, F'ij aux niveaux "0" et "1" alors, les transistors T'ij et X'ij se trouvant en conduction, le bus B'j imposera son niveau à la borne F'ij et la bascule FFij changera d'état. Le transistor Xij se trouvant par contre à l'état bloqué, il ne peut pas contribuer au changement d'état de la bascule.

Une mémoire à accès aléatoire comportant des cellules identiques à la cellule Mij, ces cellules étant disposées suivant m lignes et n colonnes, est représentée sur la figure 3.

Les cellules d'une ligne sont reliées à une ligne d'adressage Li (i = 1 à m), et les cellules d'une colonne à deux bus Bj, B'j (j = 1 à n), ces lignes d'adressage et ces bus étant connectés à un circuit de commande 10. Ce circuit comporte un bus LI d'adresse des lignes, un bus CO d'adresse des colonnes, un bus de données DO permettant d'introduire dans la mémoire, ou d'extraire de cette mémoire, une information, et un bus de commande COM permettant d'introduire dans le circuit un code déclenchant le processus de lecture ou d'écriture d'une information.

Lorsque toutes les lignes d'adressage et tous les bus sont au niveau logique "0", les cellules de la mémoire se trouvent dans un mode non-opérationnel.

Pour lire l'information contenue, par exemple, dans la cellule Mij, il faut d'abord introduire sur les bus LI et CO l'adresse de cette cellule, et sur le bus COM le code correspondant à l'opération de lecture. Le circuit 10 précharge au niveau logique "1" les bus Bj, B'j. Ensuite, ce circuit porte la ligne d'adressage Li au niveau logique "1", ce qui fait prendre aux bus Bj, B'j des niveaux logiques correspondant à l'information contenue dans la cellule Mij, sans risquer de modifier l'information des autres cellules de la ligne i puisque leur bascule est isolée des bus. Les niveaux logiques des bus Bj, B'j sont lus par un amplificateur différentiel dont la sortie fournit sur le bus DO l'information désirée. Le processus de lecture est finalement achevé par la remise au niveau logique "0" de la ligne d'adressage Li et des bus se trouvant au niveau logique "1".

Pour entrer une information dans la cellule Mij, il suffit, après avoir introduit l'adresse de la cellule et le code correspondant à l'écriture sur les bus LI, CO et COM, d'introduire encore sur le bus DO l'information devant être inscrite. Le circuit 10 porte alors les bus Bj, B'j aux niveaux logiques représentatifs de cette information, puis la ligne d'adressage Li au niveau logique "1" pour introduire l'information dans la cellule Mij, sans risquer de modifier l'information des autres cellules de la ligne i puisque ces cellules se trouvent isolées de leurs bus. Le processus d'écriture, qui ne fait pas usage du mode de précharge, est finalement achevé par la remise au niveau logique "0" de la ligne d'adressage Li et du bus se trouvant au niveau logique "1".

Le circuit de commande 10 ne sera pas décrit car, connaissant les signaux qu'il doit fournir, sa réalisation est à la portée de l'homme de l'art.

Dans la mémoire selon l'invention, l'opération d'écriture ne nécessite aucune précharge, alors que dans l'opération de lecture il n'y a lieu de ne précharger qu'un seul bus par bit de sortie. En comparaison, dans la mémoire connue de l'art antérieur, l'écriture et la lecture nécessitent la précharge de tous les bus. Il en résulte que, si le nombre de colonnes par bit de sortie est supérieur à 2, la mémoire selon l'invention présentera un avantage du point de vue consommation sur l'autre mémoire, et cet avantage sera d'autant plus marqué que n est grand.

Il est bien entendu que la mémoire qui vient d'être décrite peut faire l'objet de modifications ou variantes, sans sortir du cadre de la présente invention.

## Revendications

1. Mémoire statique comportant une pluralité de cellules identiques (Mij) disposées selon m lignes et n colonnes et auxquelles sont connectés m lignes d'adressage (Li) et 2n bus d'information (Bj, B'j), chaque cellule étant constituée d'une bascule bistable (FFij) et de deux interrupteurs (Tij, T'ij) commandés par une ligne d'adressage et reliant, chacun, une borne de sortie (Fij, F'ij) de la bascule à un bus d'information, et caractérisée en ce que chaque cellule comporte, en outre, des moyens d'isolement (Xij, X'ij) connectés, chacun, entre une des bornes de sortie (Fij, F'ij) de la bascule et le bus d'information (Bj, B'j) qui lui correspond, en série avec un des interrupteurs, et dont la conduction, respectivement le blocage, est contrôlée par l'état du bus (B'j, Bj) correspondant à l'autre borne de sortie (F'ij, Fij) de la bascule.

2. Mémoire selon la revendication 1, caractérisée en ce qu'elle est réalisée en technologie CMOS, en ce que lesdites bascules (FFij) sont formées, chacune, de deux inverseurs bouclés et en ce que lesdits interrupteurs (Tij, T'ij) et lesdits moyens d'isolement (Xij, X'ij) sont constitués, chacun, par un transistor MOS.

3. Procédé pour l'inscription d'une information dans une ou plusieurs cellules d'une ligne de la mémoire selon la revendication 1 ou la revendication 2, caractérisé en ce qu'il consiste à :

    — sélectionner ladite ligne d'adressage (Li) correspondante et commander la mise en conduction de tous lesdits interrupteurs (Fij, F'ij) des cellules (FFij) connectées à ladite ligne ;

    — envoyer, sur le bus d'information de ladite (Bj, B'j) ou desdites cellules à inscrire, l'information requise ; et

    — isoler les autres cellules de la ligne sélectionnée en mettant leurs bus d'information dans un état logique propre à assurer le blocage desdits moyens d'isolement (Xij, X'ij).

4. Procédé pour la lecture d'une information dans une ou plusieurs cellules d'une ligne de la mémoire selon la revendication 1 ou la revendication 2, caractérisé en ce qu'il consiste à :

    — commander le blocage des interrupteurs (Tij, T'ij) commandés par les lignes d'adressage (Li) de la mémoire ;

    — précharger les bus d'information (Bj, B'j) de ladite ou desdites cellules à lire ;

    — sélectionner ladite ligne d'adressage correspondant à ladite ou auxdites cellules à lire ;

    — lire l'information de ladite ou desdites cellules à lire sur les bus d'information correspondants ; et

    — isoler les autres cellules de la ligne sélectionnée en mettant leurs bus d'information dans un état logique propre à assurer le blocage desdits moyens d'isolement (Xij, X'ij).

## Patentansprüche

1. Statischer Speicher, umfassend eine Mehrzahl von identischen Zellen (Mij), die in m Zeilen und n Spalten angeordnet sind und an die m Adressleitungen (Li) und 2n Informationsbuse (Bj, B'j) angeschlossen sind, wobei jede Zelle aus je einem Flip-Flop (FFij) und zwei Unterbrechern (Tij, T'ij) besteht, die von einer Adressleitung gesteuert sind und jeweils einen Ausgang (Fij, F'ij) des Flip-Flops mit einem Informationsbus verbinden, **dadurch gekennzeichnet, daß** jede Zelle weiterhin Trennelemente (Xij, X'ij) umfaßt, die zwischen einen der Ausgänge (Fij, F'ij) des Flip-Flops und den ihm zugeordneten Informationsbus (Bij, B'ij) in Reihe mit einem der Schalter geschaltet sind und deren Leitung bzw. Unterbrechung vom Zustand des dem anderen Ausgang (F'ij, Fij) des Flip-Flops zugeordneten Buses (B'j, Bj) gesteuert wird.

2. Speicher nach Anspruch 1, dadurch gekennzeichnet, daß er in CMOS-Technologie hergestellt ist, daß die Flip-Flops (FFij) jeweils aus zwei kreuzgekoppelten Invertern bestehen, und daß die Schalter (Tij, T'ij) und die Trennelemente (Xij, X'ij) jeweils aus einem MOS-Transistor bestehen.

3. Verfahren zum Einschreiben einer Information in eine oder mehrere Zellen einer Speicherzeile nach Anspruch 1 oder 2, gekennzeichnet durch die Schritte :

— Auswählen der entsprechenden Adressleitung (Li) und Einschalten aller Unterbrecher (Tij, T'ij) der Zellen (FFij), die mit der genannten Leitung verbunden sind ;

— Abgabe der erforderlichen Information über den Informationsbus (Bj, B'j) der einzuschreibenden Zelle oder Zellen ; und

— Trennen der anderen Zellen von der ausgewählten Leitung, indem ihr Informationsbus in einen logischen Zustand gebracht wird, der geeignet ist, die Unterbrechung der Trennelemente (Xij, X'ij) zu sichern.

4. Verfahren zum Auslesen einer Information aus einer oder mehreren Zellen einer Speicherzeile nach Anspruch 1 oder 2, gekennzeichnet durch die Schritte :

— Bewirken der Unterbrechung der Unterbrecher (Tij, T'ij), die über die Adressleitungen (Li) des Speichers gesteuert sind,

— Vorbelegen des Informationsbuses (Bj, B'j) der auszulesenden Zelle oder Zellen ;

— Auswählen der Adressleitung, zugeordnet der oder den auszulesenden Zellen ;

— Auslesen der Information der Zelle oder Zellen über den entsprechenden Informationsbus ; und

— Trennen der anderen Zellen auf der ausgewählten Leitung, indem ihr Informationsbus in einen logischen Zustand gebracht wird, der geeignet ist, die Unterbrechung der Trennelemente (Xij, X'ij) zu sichern.

T'ij) and the said isolation means (Xij, X'ij) each consist of an MOS transistor.

3. Method for writing data in one or more cells in a row of the memory according to claim 1 or claim 2, characterised in that it consists of :

— selecting the said corresponding address line (Li) and making conductive all the said switches (Fij, F'ij) of the cells (FFij) connected to the said line ;

— sending, on the data bus of the said (Bj, B'j) cell or cells to be written, the required data ; and

— isolating the other cells in the row selected by putting their data buses in a logic state suitable for making the said isolation means (Xij, X'ij) non-conducting.

4. Method for reading data in one or more cells in a row of the memory according to claim 1 or claim 2, characterised in that it consists of :

— making the switches (Tij, T'ij) controlled by the address lines (Li) of the memory non-conducting;

— precharging the data buses (Bj, B'j) of the said cell or cells to be read ;

— selecting the said address line corresponding to the said cell or cells to be read ;

— reading the data from the said cell or cells to be read onto the corresponding data buses ; and

— isolating the other cells in the row selected by putting their data buses in a logic state suitable for making the said isolation means (Xij, X'ij) non-conducting.

## Claims

1. Static memory having a plurality of identical cells (Mij) arranged in m rows and n columns and to which are connected m address lines (Li) and 2n data buses (Bj, B'j), each cell consisting of a bistable flip-flop (FFij) and two switches (Tij, T'ij) controlled by an address line and each connecting an output terminal (Fij, F'ij) on the flip-flop to a data bus, and characterised in that each cell has, in addition, isolation means (Xij, X'ij) each connected between one of the output terminals (Fij, F'ij) on the flip-flop and the data bus (Bj, B'j) which corresponds to it, in series with one of the switches, and whose conduction, or alternatively non-conduction, is controlled by the state of the bus (B'j, Bj) corresponding to the other output terminal (F'ij, Fij) on the flip-flop.

2. Memory according to claim 1, characterised in that it is produced in CMOS technology, in that the said flip-flops (FFij) are each formed by two cross-coupled inverters and in that the said switches (Tij,

Fig. 1

Fig.2

Fig.3